# EUROPEAN PATENT APPLICATION

(11) **EP 4 811 947 A1**
(43) Date of publication of application: **23.09.2026**
(21) Application number: 26166227.4
(22) Date of filing: 19.03.2026
(51) Int. Cl.: H05K 7/20

(54) **COOLING SYSTEM FOR VARIABLE FREQUENCY DRIVE**

(30) Priority: 19.03.2025 US 202563774283 P
(71) Applicant: Carrier Corporation, Palm Beach Gardens, FL 33418 (US)
(72) Inventor: BORISOV, Konstantin, East Syracuse, NY, 13057 (US); CAKMAKCI, Sakin, Charlotte, NC, 28269 (US); MCDONOUGH, Scott, Charlotte, NC, 28269 (US)
(74) Representative: Dehns

(57) **Abstract**

A cooling system for variable frequency drive (VFD) (102) and/or oil-cooled device (103), is disclosed. The cooling system includes a heat exchanger (104) operatively connected to cooling source component (106) and the VFD (102). The cooling system includes a first coolant circuit (108) routed through the heat exchanger (104) and the VFD (102), and a second coolant circuit (110) routed through the heat exchanger (104) and the cooling source component (106). The cooling system includes a double-shafted pump (112) connected to the first coolant circuit (108) and/or the second coolant circuit (110), and configured to circulate first coolant through the first coolant circuit (108) and second coolant through the second coolant circuit (110) for cooling the VFD (102). The first coolant circuit (108) and/or the second coolant circuit (110) includes a three-way valve (114a) and/or a thermostatic valve (114b) defining a bypass (116a, 116b, 116c) on the first coolant circuit (108) for the first coolant exiting the heat exchanger (104), or the second coolant circuit (110) for the second coolant exiting or entering into the heat exchanger (104).

## Description

### CROSS-REFERENCE TO RELATED APPLICATION

This patent application claims the benefit of U.S. Provisional Patent Application No. 63/774,283, filed on March 19, 2025, which is incorporated by reference herein in its entirety.

### BACKGROUND

The subject disclosure relates to the field of chillers, and more particularly, to a cooling system for a variable frequency drive (VFD) of a chiller.

### SUMMARY

Described herein is a cooling system for a variable frequency drive (VFD). The cooling system comprises a heat exchanger, a first coolant circuit routed through the heat exchanger and the VFD, and a second coolant circuit routed through the heat exchanger and a cooling source component. Further, the cooling system comprises a double-shafted pump connected to the first coolant circuit and the second coolant circuit, and configured to circulate a first coolant through the first coolant circuit and a second coolant through the second coolant circuit for cooling the VFD.

In one or more embodiments, the VFD comprises a heat sink configured to eject heat from the VFD to the first coolant in the first coolant circuit.

In one or more embodiments, the cooling system comprises a thermostatic valve and a three-way valve defining a bypass on the first coolant circuit.

In one or more embodiments, the thermostatic valve and/or the three-way valve are configured to split the first coolant exiting the VFD into a first volume and a second volume, and route the first volume to the VFD through the bypass, and the second volume to the VFD through the heat exchanger.

In one or more embodiments, the first volume is mixed with the second volume flowed through the heat exchanger at the thermostatic valve or at the three-way valve placed downstream of the heat exchanger on the first coolant circuit.

In one or more embodiments, the cooling system further comprises a sensor placed upstream of the VFD, and connected to the thermostatic valve via a capillary connection, wherein the sensor is configured to actuate the thermostatic valve based on a temperature of the first coolant entering into the VFD.

In one or more embodiments, the cooling system further comprises a thermostatic valve and a three-way valve defining a bypass on the second coolant circuit.

In one or more embodiments, the thermostatic valve is disposed downstream of the VFD, and the three-way valve is disposed downstream of the heat exchanger, or vice-versa.

In one or more embodiments, the cooling system further comprises a sensor placed upstream of the VFD, and connected to the thermostatic valve via a capillary connection.

In one or more embodiments, the sensor is configured to actuate the thermostatic valve based on a temperature of the first coolant entering into the VFD.

In one or more embodiments, the cooling system further comprises a thermostatic valve and a three-way valve defining a bypass on the second coolant circuit.

In one or more embodiments, the thermostatic valve and/or the three-way valve is disposed downstream of the cooling source component, and the three-way valve is disposed downstream of the heat exchanger, or vice-versa.

In one or more embodiments, the cooling system further comprises a sensor configured to actuate the thermostatic valve based on a temperature of the second coolant entering into the heat exchanger.

In one or more embodiments, the sensor is disposed upstream of the heat exchanger on the second coolant circuit.

In one or more embodiments, the sensor is disposed on the first coolant circuit.

In one or more embodiments, the sensor is coupled to the thermostatic valve via a capillary connection.

In one or more embodiments, the cooling system comprises a sensor configured to determine temperature of at least one of the first coolant or the second coolant.

In one or more embodiments, the cooling system further comprises a pair of three-way valves defining a bypass on the first coolant circuit and/or the second coolant circuit, wherein the pair of three-way valves is configured to periodically open and/or close the connections to the bypass.

In one or more embodiments, the pair of three-way valves are controlled based on temperature of either the first coolant or the second coolant determined by a sensor placed on the first coolant circuit or the second coolant circuit, respectively.

In one or more embodiments, the cooling source component comprises a condenser or an evaporator.

In one or more embodiments, the second coolant comprises condenser water or evaporator water.

In one or more embodiments, the cooling system further comprises an oil circuit associated with an oil-cooled device. The oil circuit is routed through the heat exchanger and is connected to the double-shafted pump, where the double-shafted pump is configured to circulate oil through the oil circuit.

Described herein is a cooling system for an oil-cooled device. The cooling system comprises a heat exchanger, an oil circuit routed through the heat exchanger and the oil-cooled device, and a coolant circuit routed through the heat exchanger and a cooling source component. Further, the cooling system comprises a double-shafted pump connected to the oil circuit and the coolant circuit, and configured to circulate oil through the oil circuit and a coolant through the coolant circuit.

Described herein is a method of operating a cooling system for a VFD, the cooling system including a heat exchanger, a first coolant circuit, a second coolant circuit, and a double-shafted pump connected to the first coolant circuit and the second coolant circuit, and at least one valve defining a bypass on at least one of the first coolant circuit or the second coolant circuit. The method comprises circulating, by the double-shafted pump, a first coolant through the first coolant circuit and a second coolant through the second coolant circuit;, determining a temperature of at least one of the first coolant or the second coolant downstream of at least one of the heat exchanger or a cooling source component of the second coolant circuit, and actuating the at least one valve based on the determined temperature.

The foregoing summary is illustrative only and is not intended to be in any way limiting. In addition to the illustrative aspects, embodiments, and features described above, further aspects, embodiments, features, and techniques of the subject disclosure will become more apparent from the following description taken in conjunction with the drawings.

### BRIEF DESCRIPTION OF THE DRAWINGS

The accompanying drawings are included to provide a further understanding of the subject disclosure and are incorporated in and constitute a part of this specification. The drawings illustrate exemplary embodiments of the subject disclosure and, together with the description, serve to explain the principles of the subject disclosure.

In the drawings, similar components and/or features may have the same reference label. Further, various components of the same type may be distinguished by following the reference label with a second label that distinguishes among the similar components. If only the first reference label is used in the specification, the description is applicable to any one of the similar components having the same first reference label irrespective of the second reference label.
FIGs. 1A and 1B illustrate example block diagrams of a chiller.
FIGs. 2A and 2B illustrate circuit diagrams of a cooling system for a variable frequency drive (VFD) and an oil-cooled device of a chiller, respectively.
FIGs. 3A and 3B illustrate circuit diagrams of an exemplary cooling system with a bypass installed at a first coolant circuit.
FIGs. 4A and 4B illustrate circuit diagrams of an example cooling system with a bypass installed at a second coolant circuit around a cooling source component.
FIGs. 5A and 5B illustrate circuit diagrams of an example cooling system with a bypass installed at a second coolant circuit around a heat exchanger.
FIG. 6 illustrate a flowchart of a method of operating a cooling system.

### DETAILED DESCRIPTION

The following is a detailed description of embodiments of the subject disclosure depicted in the accompanying drawings. The embodiments are in such detail as to clearly communicate the subject disclosure. However, the amount of detail offered is not intended to limit the anticipated variations of embodiments; on the contrary, the intention is to cover all modifications, equivalents, and alternatives falling within the scope of the subject disclosure as defined by the appended claims.

Various terms are used herein. To the extent a term used in a claim is not defined below, it should be given the broadest definition persons in the pertinent art have given that term as reflected in printed publications and issued patents at the time of filing.

In the specification, reference may be made to the spatial relationships between various components and to the spatial orientation of various aspects of components as the devices are depicted in the attached drawings. However, as will be recognized by those skilled in the art after a complete reading of the subject disclosure, the components described herein may be positioned in any desired orientation. Thus, the use of terms such as "above," "below," "upper," "lower," "first", "second" or other like terms to describe a spatial relationship between various components or to describe the spatial orientation of aspects of such components should be understood to describe a relative relationship between the components or a spatial orientation of aspects of such components, as the components described herein may be oriented in any desired direction.

Chillers employing variable frequency drives (VFDs) are crucial components in systems and industries that require precise and energy-efficient cooling. VFDs and other variable speed drive pumps are also desirable to customers for reducing energy at the chiller, on a plant level, for example. These chillers are employed in a wide range of applications including, without limitation, residential and commercial heating, ventilation, and air conditioning (HVAC) systems, data centers, cold storage, refrigeration systems, etc.

In existing chillers, the VFD generates heat during operation. The generated heat is transferred from the VFD to a glycol loop/circuit, and the heat from the glycol loop/circuit is transferred to a water loop/circuit via a heat exchanger. Further, water in the water loop/circuit then flows to the cooling source component to release the heat from the glycol. In this process, maintaining adequate flow of glycol and the water in both the glycol loop/circuit and the water loop/circuit is crucial for proper VFD cooling.

Without sufficient condenser water flow, the heat exchanger cannot remove heat from the glycol, leading to overheating of the VFD. This limits an operating range and performance of the chiller, as the chiller's cooling efficiency is directly tied to the customer's pump performance. Therefore, lack of effective cooling leads to overheating of the VFD, causing failures or system shutdowns. There is, therefore, a need for a solution to address the challenges posed by existing cooling systems, by providing a cooling system that avoids overheating of the VFD and effectively cools the VFD (or oil-cooled devices) independently of other operations of the chiller, thereby improving the operating range and the performance of the chiller.

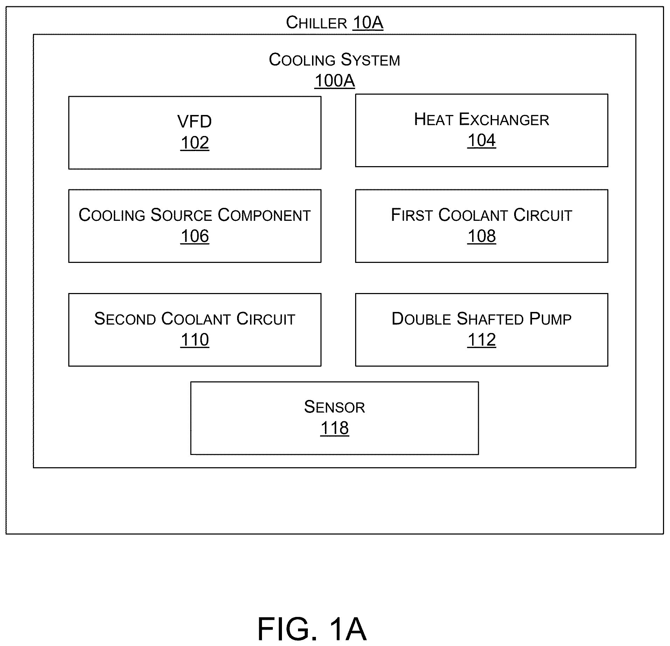

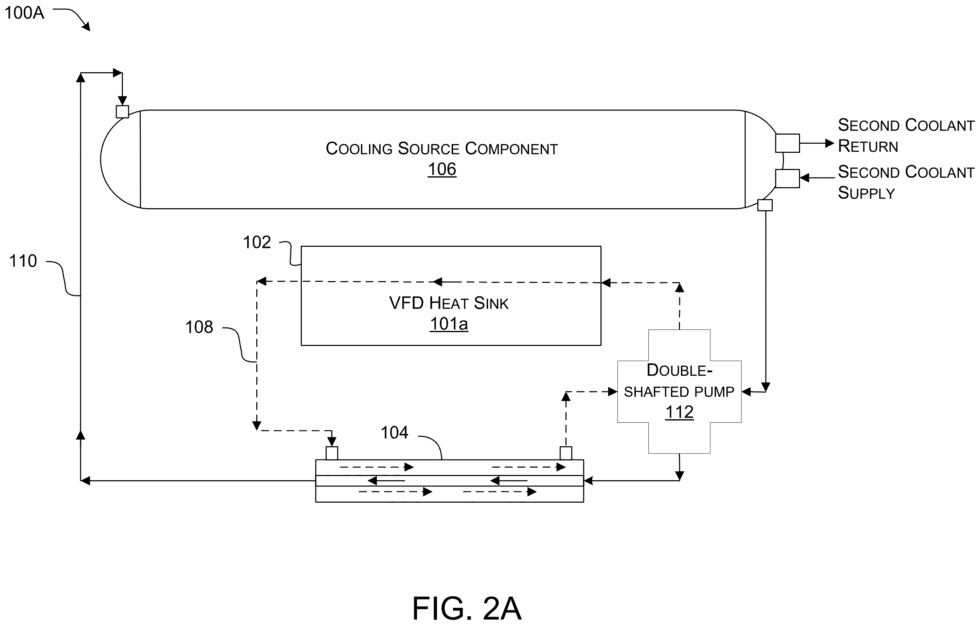

Referring to FIGs. 1A and 2A, a chiller 10A with a variable frequency drive (VFD) 102 is disclosed. The chiller 10A may include a cooling system 100A for cooling the VFD 102 of the chiller 10A. The cooling system 100A may further include a cooling source component 106, which may be a condenser or an evaporator. The cooling source component 106 may be a source of "cold" fluids or water, i.e., configured to dissipate heat from the fluids (hereafter referred to as second coolant).

Further, the cooling system 100A may include a first coolant circuit 108 routed through the heat exchanger 104 and the VFD 102, and a second coolant circuit 110 routed through the heat exchanger 104 and the cooling source component 106. A first coolant may be circulated through the first coolant circuit 108, and the second coolant may be circulated through the second coolant circuit 110. In one or more embodiments, the first coolant may be any fluid configured to absorb heat from the VFD 102 and eject heat to the heat exchanger 104. Examples of the first coolant may include any one or a combination of, glycol, water, oil, and the like, but not limited thereto. Similarly, the second coolant may be any fluid configured to absorb heat from the heat exchanger 104, and eject heat to the cooling source component 106. In one or more embodiments, the second coolant may include condenser water or evaporator water. The first coolant circuit 108 and the second coolant circuit 110 may be implemented as a set of pipes or channels that form a corresponding closed loop for circulating the first coolant and the second coolant, respectively. The first coolant circuit 108 and the second coolant circuit 110 may include corresponding portions/locations through which heat may either be absorbed or ejected.

In one or more embodiments, the VFD 102 may include or enclose a heat sink 101a (also referred to as a VFD heat sink 101a). The heat sink 101a may include a brazed plate heat exchanger. In one or more embodiments, the VFD 102 may be connected to the heat sink 101a of the cooling system 100A. In one or more embodiments, the heat sink 101a may be configured to absorb the heat within the VFD 102, to prevent overheating of the VFD 102. The heat sink 101a may also be configured to eject heat to another element, thereby allowing the heat to be rejected out from the VFD 102. In one or more embodiments, the first coolant may enter the VFD 102 and interact with the heat sink 101a, such that the heat generated within the VFD 102 may be absorbed by the first coolant via the heat sink 101a. The first coolant circuit 108 (i.e., at some pipes thereof) may be routed through the heat sink 101a, such that the first coolant flowing through the first coolant circuit 108 absorbs the heat from the heat sink 101a. The heat absorbed by the first coolant may then be ejected to the heat exchanger 104. Further, the second coolant may absorb the heat from the first coolant circuit 108 at the heat exchanger 104, and eject the heat to the cooling source component 106.

The heat exchanger 104 may be configured to facilitate the exchange of heat between the first coolant and the second coolant. In one or more embodiments, the pipes of the first coolant circuit 108 and the second coolant circuit 110 may be placed adjacent to each other. The pipes may be thermally conductive to facilitate heat exchange between the coolants. In one or more embodiments, the pipes may be arranged such that the first coolant and the second coolant move in opposite directions with respect to each other (i.e., in a counter flow arrangement). In other embodiments, the first coolant and the second coolant may move in the same direction. In one or more embodiments, the pipes of the second coolant circuit 110 may be arranged concentrically around the pipes of the first coolant circuit 108 to increase surface area through which heat exchange may occur, in the heat exchanger 104. In addition to providing cooling in the cooling system 100A, the second coolant may also be used for other purposes, such as for use in direct refrigerant cooling enclosures.

The cooling system 100A may include a double-shafted pump 112 connected to the first coolant circuit 108, and/or the second coolant circuit 110. The double-shafted pump 112 may be configured to circulate the first coolant through the first coolant circuit 108 and the second coolant through the second coolant circuit 110 for cooling the VFD 102. The double-shafted pump 112 may include two shafts, which may be driven by a common drive mechanism (such as a motor). One shaft may circulate the first coolant through the first coolant circuit 108, while the other shaft may circulate the second coolant through the second coolant circuit 110, thereby allowing for simultaneous operation/circulation through both the first coolant circuit 108 and the second coolant circuit 110. The double-shafted pump 112 may operate concurrently with the chiller 10A (or pumps thereof). Further, the use of the double-shafted pump 112 may allow diameter of pipes/channels forming the second coolant circuit 110 to be reduced. Reducing the diameter of the second coolant circuit 110 may offer significant benefits, including cost savings, improved system efficiency, compact design, and environmental advantages. These benefits may make the cooling system 100A suitable in chillers that require optimal performance and reliability. It may be appreciated that the double shafted pump 112 described herein is merely exemplary, and any pump configuration that allows for a single mechanical device to pump liquid in two or more separate circuits is contemplated within the scope of the subject disclosure.

Both the first coolant circuit 108 and the second coolant circuit 110 may be routed through the heat exchanger 104. The first coolant may act as an intermediate cooling fluid in the first coolant circuit 108, and may flow through the VFD 102. The first coolant may absorb heat generated during the operation of the VFD 102. In one or more embodiments, the VFD 102 may include a VFD heat sink 101a, which may be configured to facilitate transfer of heat from the VFD 102 to the first coolant. The heated first coolant may be directed/flowed/pumped to the heat exchanger 104 by the double-shafted pump 112, where the heated first coolant may release the absorbed heat to the second coolant in the second coolant circuit 110. Once the first coolant is cooled in the heat exchanger 104, the cooled first coolant may be recirculated back to the VFD 102 by the double-shafted pump 112, to continue absorbing heat from the VFD 102.

Further, the second coolant (i.e., condenser water or evaporator water) may be flowed through the heat exchanger 104, and the double-shafted pump 112, to absorb the heat from the first coolant. After absorbing heat, the second coolant may be directed to the cooling source component 106. At the cooling source component 106, the heat gained by the second coolant may be dissipated into the cooling source component 106, and the cooled second coolant may be returned to the heat exchanger 104 to repeat the process, thereby ensuring efficient cooling of the VFD 102 by separating an internal heat transfer process (first coolant circuit) from an external heat dissipation process (second coolant circuit). This may also prevent overheating of the VFD 102 and maintain optimal operating conditions for the VFD 102. In FIGs. 2A to 5B, the flow of the first coolant is shown using dashed arrowed lines, and the flow of the second coolant is shown using solid lines.

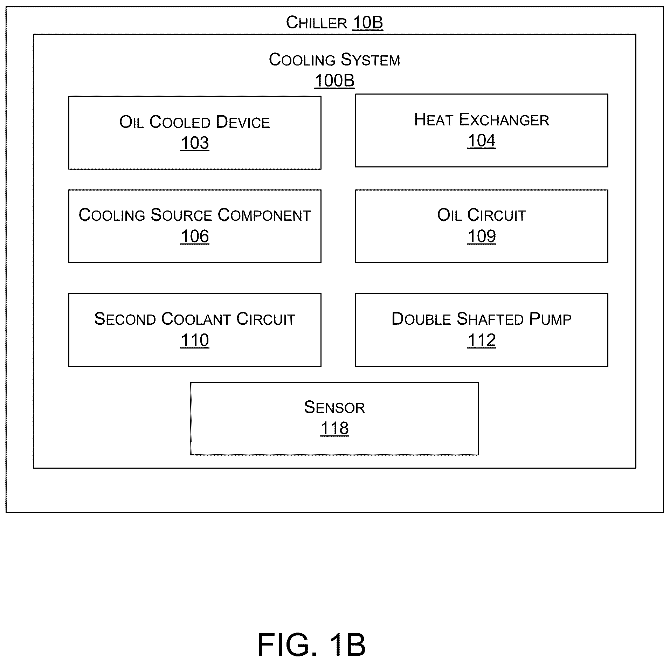

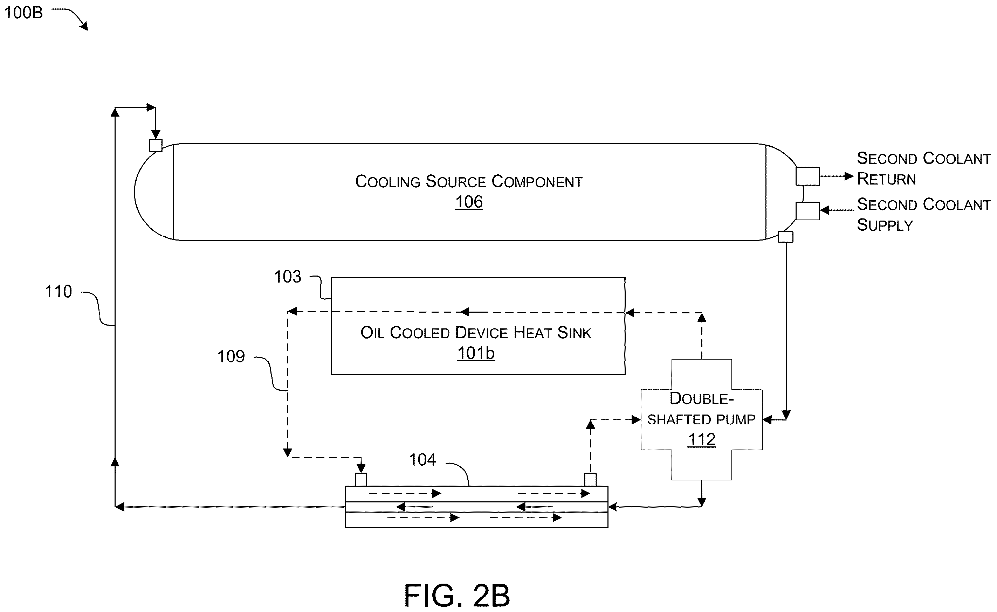

In one or more embodiments, other fluid circuits may be installed in alternative to, or in addition to, the first coolant circuit 108, as shown in FIGs. 1B and 2B.

Referring to FIGs. 1B and 2B, another chiller 10B having another cooling system 100B with an oil-cooled device 103 is shown. While the chiller 10B may be substantially similar to the chiller 10A, the cooling system 100B of the chiller 10B may include an oil circuit 109 routed through the heat exchanger 104 and the oil-cooled device 103, instead of the first coolant circuit 108 routed through the VFD 102. In addition, the double-shafted pump 112 of the chiller 10B may be connected to the oil circuit 109, to circulate oil through the oil circuit 109 and the second coolant through the second coolant circuit 110 for cooling the oil-cooled device 103. Further, in one or more embodiments, the oil-cooled device 103 may be integrated with a corresponding heat sink (also referred to as an oil-cooled device heat sink 101b). The oil-cooled device heat sink 101b may be placed inside the oil-cooled device 103. The oil-cooled device may be configured to absorb heat generated within the oil-cooled device 103. Further, the oil-cooled device heat sink 101b may transfer the absorbed heat to the oil circulating through the oil circuit 109, and which in turn may eject heat to the heat exchanger 104. Hereafter, the term 'heat sink 101' may be used to collectively or individually refer to the heat sinks 101a, 101b.

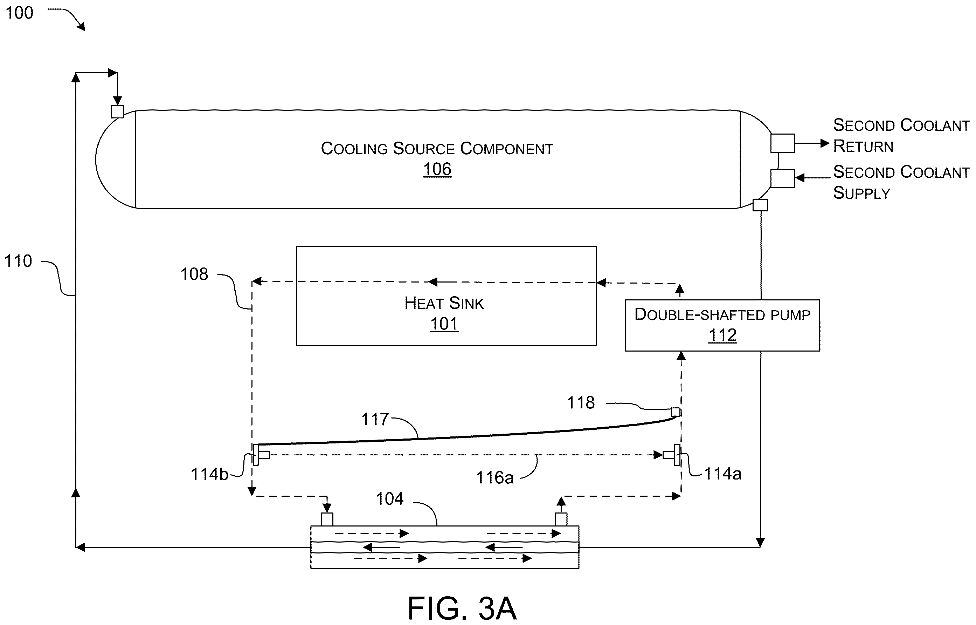

In some situations, the temperature of the first coolant may be approaching or be less than a dew point, which may lead to condensation at the VFD 102 and/or the oil-cooled device 103. Condensation may be undesirable, as it may be damaging and cause electrical issues. To prevent condensation, a bypass line may be provided in the first coolant circuit 108/the oil circuit 109, and/or the second coolant circuit 110, as described in reference to FIGs. 3A to 5B.

Referring to FIG. 3A, the cooling systems 100A, 100B (collectively referred as cooling system 100) may include at least one three-way valve 114a and/or at least one thermostatic valve/three-way temperature actuated modulating valve 114b in the first coolant circuit 108/oil circuit 109. In one or more embodiments, the three-way valve 114a may be disposed downstream of the heat exchanger 104, and the thermostatic valve 114b may be disposed upstream of the heat exchanger 104. In one or more embodiments, the thermostatic valve 114b may be disposed downstream of the VFD 102, and the three-way valve 114a may be disposed downstream of the heat exchanger 104, or vice-versa. The thermostatic valve 114b may be configured to open and/or close (and thereby allow or prevent circulation of the first coolant therethrough, respectively) at least one of the valves 114a, 114b.

The three-way valve 114a and the thermostatic valve 114b may define a bypass line/bypass 116a therebetween in the first coolant circuit 108 that allows at least some volume of the first coolant to flow/be routed bypassing the heat exchanger 104 (i.e., without flowing through the heat exchanger 104). In some embodiments, the bypass 116a may be formed through by a fluidic connection between the three-way valve 114a and the thermostatic valve 114b, such as by a pipe or a channel. By integrating the bypass 116a and the valves 114a, 114b, the cooling system 100 may enhance flexibility, reliability, and efficiency in managing the temperature of the first coolant in the first coolant circuit 108.

The thermostatic valve 114b may be operably configured to split the first coolant into one or more portions or volumes. In one or more embodiments, thermostatic valve 114b may be configured to split the first coolant into a first volume to be routed from the VFD 102 through the bypass 116a, and/or a second volume to be routed through the heat exchanger 104, the second volume being cooled by the heat exchanger 104. The regular three-way valve 114a may allow the first volume passing through and exiting the bypass 116a and the second volume passing through and exiting the heat exchanger 104 (or first and second volumes of the oil from the oil-cooled device 103 in case of chiller 10B) to be mixed in the three-way valve 114a or proximately to the three-way valve 114a in the first coolant circuit 108.

For instance, a consolidated volume of the first coolant heated by the heat sink 101a or 101b (collectively referred to as heat sink 101) may be flowed through the first coolant circuit 108. At the thermostatic valve 114b, the first coolant may be split into the first volume (which may be directed/routed through the bypass 116a) and the second volume (which may be directed/routed through the heat exchanger 104). Then, the first volume and the second volume may be mixed at the other valve 114a (or any other mixing point/junction where the bypass 116a reconnects with the first coolant circuit 108). The mixing may average the temperature of the first volume (which retains the heat absorbed from the heat sink 101) and the second volume (which may have dissipated the heat through the heat exchanger 104), such that the first coolant has a temperature above the dew point, thereby preventing condensation at the VFD 102. It may be appreciated that the oil circuit 109 of the cooling system 100B may be suitably adapted to mix different volumes of the oil to control the temperature thereof, and prevent condensation at the oil-cooled device 103.

In one or more embodiments, a (temperature) sensor 118 may be placed on the first coolant circuit 108. In one or more embodiments, the sensor 118 may be placed downstream of the thermostatic/three-way temperature actuated valve 114b, or upstream of the heat sink 101/VFD 102, as illustrated in FIG. 3A. In one or more embodiments, the sensor 118 may be a thermistor, configured to determine the temperature of the mixed volumes of the first coolant, and transmit the determined temperature as electrical signals through a capillary connection 117, which may actuate the thermostatic valve/three-way temperature actuated valve 114b based on a temperature of the (mixed) first coolant upstream of the heat sink 101/VFD 102. In one or more embodiments, the thermostatic valve 114b may be closed when the temperature of the mixed first coolant exceeds a temperature threshold, and may be opened when the temperature of the mixed first coolant is less than another temperature threshold.

In other embodiments, the sensors 118 (and/or a controller implementing the thermostatic valve 114b actuatable by the sensor 118) may be configured to determine the temperature of the 'mixed' first volume and the second volume, and adjust the mixing of the first volume and the second volume to maintain a preset/desired temperature range. In one or more embodiments, the three-way valves 114a and/or the thermostatic valves 114b may include two input ports and one output port, or one input port and two output ports. The input ports and output ports may be opened or closed to allow the first coolant to control the flow of the first coolant therethrough. For example, if the sensor 118/controller detects the temperature of the first coolant to be approaching the dew point, a signal from the sensor 118 may cause the thermostatic valve 114b to open the bypass 116a, thereby allowing the first coolant to split into, and mix the first and second volumes to average (or increase) the temperature. In one or more embodiments, when the temperature of the first coolant/oil continues to approach the dew point despite the first and the second volumes being mixed, the thermostatic valve 114b may close the connection towards the heat exchanger 104, thereby allowing the first coolant/oil to circulate in a closed loop through the heat sink 101 and the bypass 116a. In such embodiments, the first coolant may continually absorb heat from the heat sink 101, until the temperature increases to a value within the desired temperature range to avoid condensation.

In one or more embodiments, if the temperature determined by the sensor 118 is outside the maximum or minimum limit or range of the second coolant entering into the heat exchanger 104, where the VFD 102 or the oil-cooled device 103 may become vulnerable to overheating, the sensor 118 may be configured to open or control(/increase) flow rate of the second volume going towards the heat exchanger 104. In some embodiments, the sensor 118 may also transmit control signals to close or control/limit the flow of the first volume through the bypass 116a. The first coolant heated by the heat sink 101 may be continued to be circulated through the heat exchanger 104, until the temperature of the first coolant reduces to a value within the temperature range (i.e., below the maximum temperature limit).

In one or more embodiments, the three-way valve 114a, and the thermostatic valve 114b (or a pair of three-way valves) may periodically open and/or close the connections to the bypass 116a and/or the heat exchanger 104 to control the ratio of the first volume and the second volume being mixed, to adjust the temperature of the first coolant/oil being flowed through the heat sinks 101 corresponding to the VFD 102/oil-cooled device 103. In other embodiments, the thermostatic valve/three-way temperature actuated modulating valve 114b may allow the flow rate of the first and/or second volumes to be controlled.

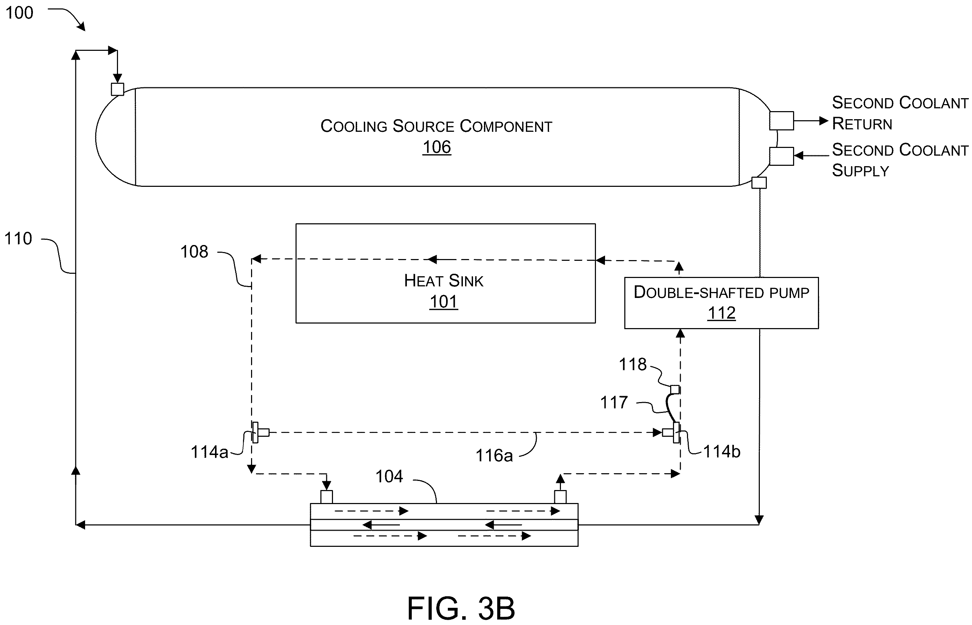

FIG. 3B represents an alternate cooling configuration where positions of the thermostatic valve/three-way temperature modulating valve 114b and the regular three-way valve 114a may be switched, and the sensor 118 may be positioned in proximity to or embedded within the thermostatic valve/three-way temperature modulating valve 114b. In embodiments where the sensor 118 is integrated within the three-way temperature modulating valve 114b, the capillary connection 117 may not be needed. The cooling pathway adjustments may allow the cooling system 100 to react to varying heat loads efficiently.

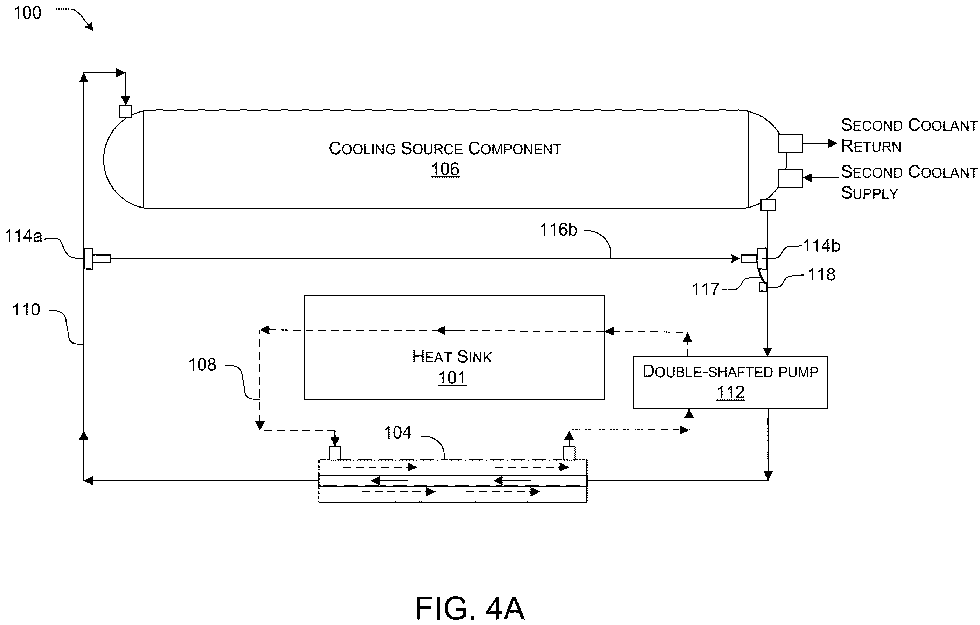

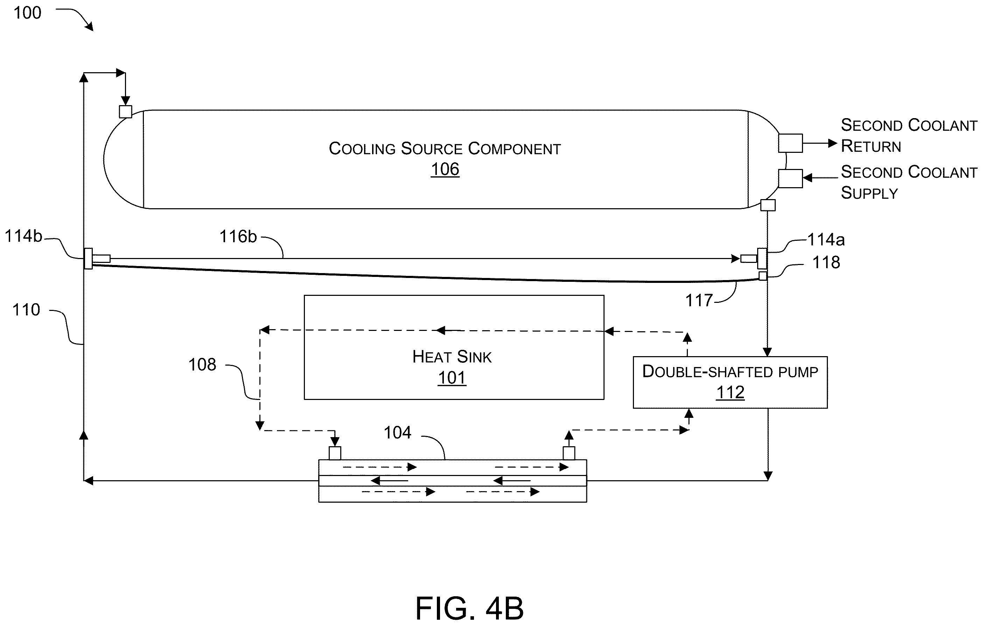

Referring to FIGs. 4A and 4B, in one or more embodiments, the three-way valve 114a and the thermostatic valve 114b may be disposed in the second coolant circuit 110, in contrast to embodiments shown in FIGs. 3A and 3B. As shown, the cooling system 100 may include the heat sink 101 (either associated with the VFD 102 or the oil-cooled device 103), which may be configured to absorb heat from the VFD 102 or the oil-cooled device 103, and eject heat to the first coolant being circulated through the first coolant circuit 108. The first coolant, after absorbing heat from the heat sink 101, may be circulated through the heat exchanger 104 where the absorbed heat may be ejected to the second coolant through the heat exchanger 104. The second coolant may absorb the heat from the heat exchanger 104, and eject the heat to the cooling-source component 106. The double-shafted pump 112 may be configured to circulate both the first coolant through the first coolant circuit 108, and the second coolant through the second coolant circuit 110.

As shown, the three-way valve 114a and the thermostatic valve 114b may define a bypass 116b in the second coolant circuit 110. In one or more embodiments, the thermostatic valve 114b and/or the three-way valve 114a may be disposed downstream of the cooling source component 106, and the three-way valve 114a may be disposed downstream of the heat exchanger 104, or vice-versa. The bypass 116b may be configured to allow a first volume of the second coolant exiting (or heated by) the heat exchanger 104 and a second volume of the second coolant cooled by the cooling source component 106 to be mixed in the thermostatic valve 114b. The thermostatic valve/three-way temperature actuated modulating valve 114b in the second coolant circuit 110 may be configured to operably open and/or close based on a determined temperature of the second coolant at the three-way valve where the first and second volume of the second coolant is mixed (i.e., upstream of the heat exchanger 104 on the second coolant circuit 110), as determined by the sensor 118/controller, thereby regulating heat transfer rate between the first and second coolant in the heat exchanger 104. In one or more embodiments, the sensor 118 may be disposed upstream of the heat exchanger 104 on the second coolant circuit 110. The sensor 118/controller may be configured to open or close the three-way temperature modulating valve 114b using the capillary connection 117 therebetween. In embodiments where sensor 118/controller is embedded within the thermostatic valve/three-way temperature modulating valve 114b, the capillary connection 117 may not be needed. Embodiments where the three-way temperature modulating valve/thermostatic valve 114b is placed downstream of the cooling-source component 106, as shown in FIG. 4A, may be preferred embodiments.

In one or more embodiments, the three-way temperature modulating valve/thermostatic valve 114b may be placed upstream of the cooling source component 106 and the three-way valve 114a may be placed downstream of the cooling source component 106, as shown in FIG. 4B. In such embodiments, the sensor 118/controller may be placed downstream of the cooling source component 106, and may be connected to thermostatic valve 114b via the capillary connection 117.

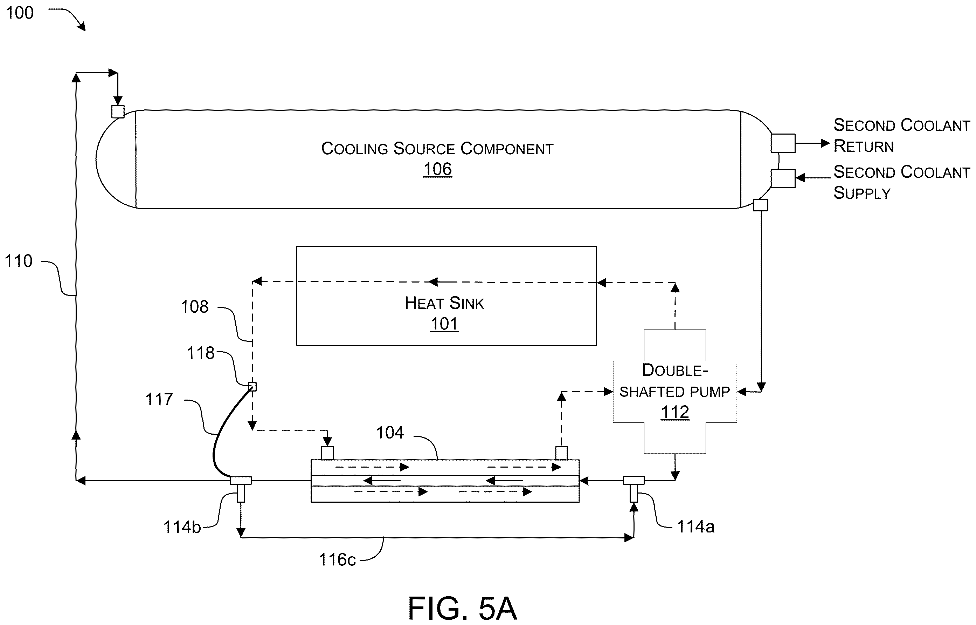

Referring to FIG. 5A, in one or more embodiments, the three-way valve 114a and the thermostatic valve 114b may be disposed in the second coolant circuit 110, defining a bypass 116c around the heat exchanger 104. The bypass 116c may allow the heated second coolant exiting the heat exchanger 104 to be mixed with the cooled second coolant from the cooling source component 106.

The second coolant may be cooled at the cooling source component 106, and circulated through the second coolant circuit 110. The second coolant circuit 110 is routed through the heat exchanger 104, to allow the 'cooled' second coolant to absorb heat from the first coolant. The now 'heated' second coolant may exit the heat exchanger 104.

The thermostatic valve 114b (as shown in FIG. 5A) may be configured to split the heated second coolant exiting the heat exchanger 104 into a first volume and a second volume of the heated second coolant. The first volume may be circulated/routed to the cooling source component 106 directly, where the heat from the first volume may be ejected. The first volume may then be circulated/routed towards the heat exchanger 104 from the cooling source component 106. The second volume may be circulated/routed back upstream of the heat exchanger 104, thereby allowing the second volume of the heated second coolant to be mixed with the cooled second coolant being circulated to the heat exchanger 104 from the cooling source component 106. The mixing of the second volume and the cooled second coolant may average (or increase) the temperature of the second coolant entering into the heat exchanger 104, thereby preventing condensation and/or scaling at the heat exchanger 104, and the heat sink 101 (or the VFD 102/oil-cooled device 103 associated therewith). The bypass 116c may be opened or closed based on the temperature sensed by the sensor 118 at the thermostatic valve 114b placed downstream of the heat exchanger 104 on the second coolant circuit 110.

The sensor 118/controller may be placed downstream of the heat sink 101 on the first coolant circuit 108, to determine temperature of the first coolant exiting the heat sink 101. Based on the determined temperature, the sensor 118/controller may dynamically control mixing of the first volume and the second volume to maintain a preset temperature by opening or closing the thermostatic valve/three-way temperature modulating valve 114b, ensuring the mixed coolant entering the heat exchanger 104 is within the desired temperature range. The sensor 118/controller may be configured to control (i.e., open or close) the thermostatic valve/three-way temperature modulating valve 114b using the capillary connection 117 extending therebetween.

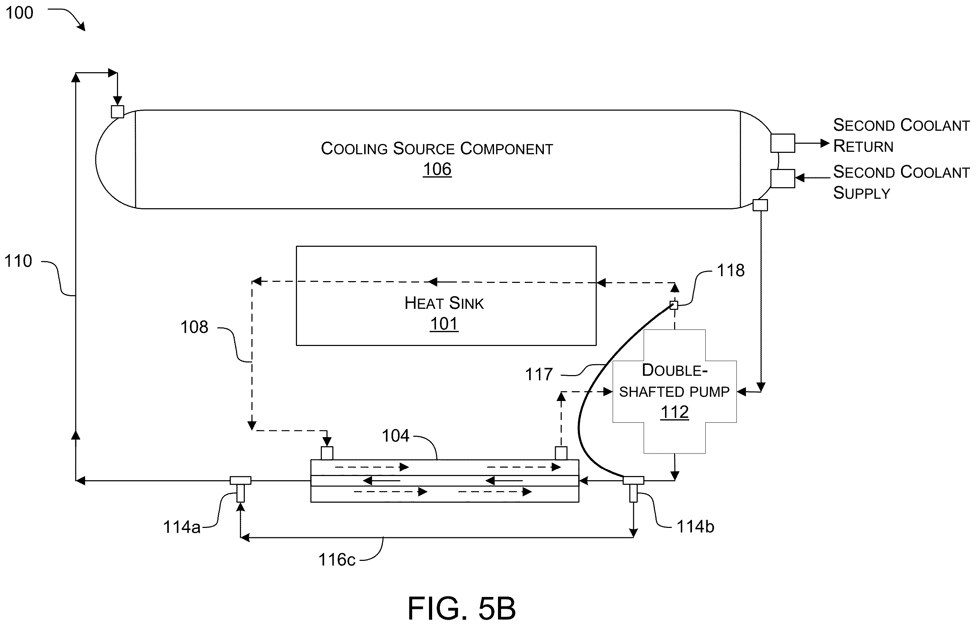

FIG. 5B represents an alternative configuration, where the sensor 118/controller, the bypass 116c, and coolant flow directions are arranged differently in comparison to FIG. 5A. In FIG. 5B, the sensor 118/controller may be repositioned to determine the temperature of the first coolant. In one or more embodiments, the sensor 118 may be disposed on the first coolant circuit 108. Further, the thermostatic valve 114b may be disposed upstream of the heat exchanger 104 on the second coolant circuit 110, and the regular three-way valve 114a may be disposed downstream of the heat exchanger 104. Further, the sensor 118/controller may be positioned upstream of the heat sink 101, or downstream of the heat exchanger 104 on the first coolant circuit 108. The thermostatic valve 114b may react to the sensor 118/controller via the capillary connection 117. If the temperature of the first coolant entering the heat sink 101 is less than a threshold temperature, the sensor 118/controller may transmit a signal through the capillary connection 117 to actuate the thermostatic valve 114b to split the second coolant entering the thermostatic valve 114b to the bypass 116c and the heat exchanger 104. The second coolant may be split into a first volume and a second volume, and route the first volume to the cooling source component 106 through the bypass 116c, and the second volume to the heat exchanger 104. Similarly, if the temperature of the first coolant entering into the heat sink 101 is greater than another threshold temperature, the sensor 118/controller 300 may transmit a signal through the capillary connection 117 to the thermostatic valve 114b to close the second coolant entering the bypass 116c, causing all the second coolant exiting the thermostatic valve 114b to be diverted to heat exchanger 104.

To further enhance an efficiency of the cooling system 100 and prevent operational issues caused by condensation, the three-way valve 114a and the thermostatic valve 114b may be integrated into either the first coolant circuit 108 and/or the second coolant circuit 110. The three-way valve 114a and the thermostatic valve 114b may ensure that the temperature of the first coolant may be maintained above a dew point (for example) by mixing the first volume of the first coolant heated by the heat sink 101 and the second volume of the first coolant cooled by the heat exchanger 104, in alternative or in addition to the valves provided in the first coolant circuit 108. Maintaining the temperature of the first coolant and/or the second coolant may prevent condensation on the VFD 102/oil-cooled device 103, ensuring consistent performance and reducing maintenance requirements of the chiller 10A/10B.

While some embodiments with different positions/arrangements for the sensor 118/controller, the three-way valve 114a and the thermostatic valve 114b, the bypasses (116a, 116b, 116c), and the capillary connection 117 are shown, it may be appreciated that the cooling system 100 may be suitably adapted to have any other arrangement of the aforesaid components, without deviating from the scope of the subject disclosure.

Therefore, by implementing different cooling configurations, the cooling system 100 may provide flexibility in thermal management strategies, enhance heat dissipation efficiency, preventing overheating and ensuring stable operation of the VFD 102 (or other oil-cooled devices 103), and optimizes the interaction between first and second coolants, ensuring effective heat removal and temperature regulation.

Thus, the subject disclosure (i.e., cooling system 100) overcomes the drawbacks, limitations, and shortcomings associated with existing cooling systems by providing an improved and effective solution that reduces dependency on the external pump, and prevents issues like scaling and condensation in the heat exchanger 104 or any associated components, leading to improved performance and lower maintenance cost. The double-shafted pump 112 employed in the second coolant circuit 110 of the cooling system 100 may ensure consistent second coolant flow. The double-shafted pump 112 may be dynamically adjusted to overcome pressure drops in the second coolant circuit 110, ensuring steady flow therethrough. The double-shafted pump 112 may allow the cooling system 100 to operate independently, ensuring uninterrupted cooling of the VFD 102, thereby extending the operational range of the chiller 10A/10B. The double-shafted pump 112 may optimize flow and pressure of the first and second coolant through respective circuits or bypasses therein, reducing energy consumption during low-load conditions. Furthermore, using the double-shafted pump 112 in the cooling system 100 may reduce labor (i.e., for installation and maintenance) and component costs, as both shafts of the double-shafted pump 112 may be driven by the same motor (or driving mechanism). Using a single driving mechanism for both the shafts implies that the double-shafted pump 112 may require less installation space compared to two separate pumps, making it ideal for compact chiller designs where space is limited. Additionally, a single double-shafted pump 112 handling both the first coolant circuit 108 and second coolant circuit 110 may simplify the construction of the cooling system 100, thereby reducing maintenance complexity and potential downtime associated with managing multiple pumps.

While various embodiments of this subject disclosure have been elaborated for the cooling system including the first coolant circuit and the second coolant circuit for cooling the VFD for the sake of simplicity and better explanation purpose, however, the teachings of this subject disclosure are equally applicable for other cooling systems having the oil circuit and the second coolant circuit, or the first coolant circuit, the oil circuit, and the second coolant circuit for cooling the oil-cooled device, and all such embodiments are well within the scope of this subject disclosure.

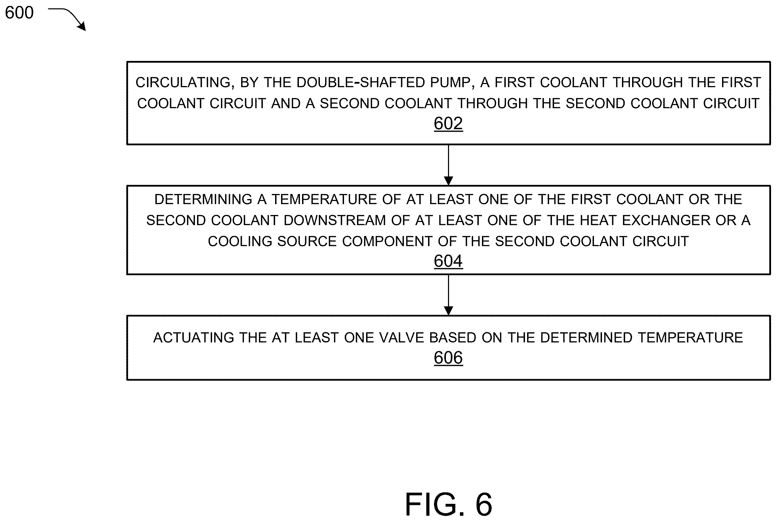

FIG. 6 illustrates a flowchart of a method 600 of operating a cooling system for a variable frequency drive (VFD), in accordance with one or more embodiments of the subject disclosure. While the method 600 is described in the context of the VFD 102, it may be appreciated that the method 600 may be suitably adapted for application with the oil-cooled device 103 and the oil circuit 109 (as shown in FIG. 2B).

At step 602, the method 600 may include circulating, by the double-shafted pump 112, a first coolant through the first coolant circuit 108 and a second coolant through the second coolant circuit 110. In one or more embodiments, the step 602 may include driving a first shaft and a second shaft of the double-shafted pump 112 simultaneously via a common motor or drive mechanism. By circulating both coolants simultaneously, the cooling system 100 ensures that heat absorbed by the first coolant at the VFD 102 may be continuously transferred to the second coolant at the heat exchanger 104. In embodiments utilizing an oil-cooled device 103, the step 602 may include circulating oil through the oil circuit 109 via the first shaft while circulating condenser/evaporator water through the second coolant circuit 110 via the second shaft. The simultaneous circulation reduces the need for multiple pumps and simplifies the control logic required to initiate cooling.

At step 604, the method 600 may include determining a temperature of at least one of the first coolant or the second coolant downstream of at least one of the heat exchanger 104 or a cooling source component 106 of the second coolant circuit 110. In one or more embodiments, the temperature may be determined by the sensor 118 (e.g., a thermistor or a temperature probe). In one or more embodiments, the temperature may be determined downstream of at least one of the heat exchanger 104 or a cooling source component 106 of the second coolant circuit 110, as they correspond to mixing points where a processed volume of the coolant (e.g., cooled by the heat exchanger 104 or the cooling source component 106) and a bypassed volume of the coolant (e.g., routed through the bypass 116a, 116b, or 116c without thermal processing) may be combined. Measuring the temperature at such mixing points allows the sensor 118 to determine a resultant temperature of the mixed coolant, thereby ensuring that the first/second coolant delivered to the VFD 102 or the heat exchanger 104 is above a corresponding dew point to prevent condensation. For instance, in embodiments where the bypass 116a is used (as in FIG. 3A), the temperature may be determined downstream of the bypass connection to assess if the mixture of the hot first coolant (from the VFD 102) and the cold first coolant (from the heat exchanger 104) is sufficiently warm to avoid condensation on the VFD 102. Similarly, in embodiments utilizing bypass 116c (as in FIG. 5A), the temperature may be determined downstream of the heat exchanger 104 to regulate the mixture of the heated second coolant and the cooled second coolant.

At step 606, the method 600 may include actuating the at least one valve based on the determined temperature. In such embodiments, the method 600 may include a controller or a capillary connection 117 physically actuating the at least one valve (such as any of a thermostatic valve 114b or a three-way valve 114a defining the bypass) to modulate a bypass flow. In one or more embodiments, actuating the valve may cause splitting the flow of the first/second coolant into a first volume directed through a bypass (e.g., 116a, 116b, or 116c) and a second volume directed through the heat exchanger 104 (or cooling source component 106). For instance, if the temperature determined at step 604 indicates the first coolant is approaching a dew point, the valve may be actuated to increase the flow of the first volume through the bypass 116a, thereby recycling heat from the VFD 102 to raise the loop temperature. Conversely, if the temperature indicates overheating/scaling, the valve may be actuated to close the bypass and direct maximum flow through the heat exchanger 104. In embodiments involving the second coolant circuit 110 (e.g., FIG. 5A), actuating the valve may route the second coolant to bypass the heat exchanger 104 to prevent over-cooling or scaling.

While the subject disclosure has been described with reference to exemplary embodiments, it will be understood by those skilled in the art that various changes may be made and equivalents may be substituted for elements thereof without departing from the scope of the subject disclosure as defined by the appended claims. Modifications may be made to adapt a particular situation or material to the teachings of the subject disclosure without departing from the scope thereof. Therefore, it is intended that the subject disclosure not be limited to the particular embodiment disclosed, but that the subject disclosure includes all embodiments falling within the scope of the subject disclosure as defined by the appended claims.

In interpreting the specification, all terms should be interpreted in the broadest possible manner consistent with the context. In particular, the terms "comprises" and "comprising" should be interpreted as referring to elements, components, or steps in a non-exclusive manner, indicating that the referenced elements, components, or steps may be present, or utilized, or combined with other elements, components, or steps that are not expressly referenced. Where the specification claims refer to at least one of something selected from the group consisting of A, B, C ....and N, the text should be interpreted as requiring only one element from the group, not A plus N, or B plus N, etc.

The following clauses set out features of the invention which may or may not presently be claimed in this application, but which may form the basis for future amendment or a divisional application.
1. A cooling system for a variable frequency drive (VFD), comprising:
   a heat exchanger;
   a first coolant circuit routed through the heat exchanger and the VFD;
   a second coolant circuit routed through the heat exchanger and a cooling source component; and
   a double-shafted pump connected to the first coolant circuit and the second coolant circuit, and configured to circulate a first coolant through the first coolant circuit and a second coolant through the second coolant circuit for cooling the VFD.
2. The cooling system of clause 1, wherein the VFD comprises a heat sink configured to eject heat from the VFD to the first coolant in the first coolant circuit.
3. The cooling system of clause 1, further comprising a thermostatic valve and a three-way valve defining a bypass on the first coolant circuit.
4. The cooling system of clause 3, wherein the thermostatic valve and/or the three-way valve are configured to split the first coolant exiting the VFD into a first volume and a second volume, and route the first volume to the VFD through the bypass, and the second volume to the VFD through the heat exchanger.
5. The cooling system of clause 4, wherein the first volume is mixed with the second volume flowed through the heat exchanger at the thermostatic valve or at the three-way valve placed downstream of the heat exchanger on the first coolant circuit.
6. The cooling system of clause 3, further comprising a sensor placed upstream of the VFD, and connected to the thermostatic valve via a capillary connection, wherein the sensor is configured to actuate the thermostatic valve based on a temperature of the first coolant entering into the VFD.
7. The cooling system of clause 1, further comprising a thermostatic valve and a three-way valve defining a bypass on the second coolant circuit.
8. The cooling system of clause 7, wherein the thermostatic valve and/or the three-way valve are configured to split the second coolant exiting the heat exchanger into a first volume and a second volume, and route the first volume to the heat exchanger through the bypass, and the second volume to the heat exchanger through the cooling source component.
9. The cooling system of clause 8, wherein the first volume is mixed with the second volume at the thermostatic valve or at the three-way valve placed upstream of the heat exchanger on the second coolant circuit.
10. The cooling system of clause 7, further comprising a sensor placed upstream of the heat exchanger on the second coolant circuit, and connected to the thermostatic valve via a capillary connection, wherein the sensor is configured to actuate the thermostatic valve based on a temperature of the second coolant entering into the heat exchanger.
11. The cooling system of clause 7, wherein the thermostatic valve and/or the three-way valve are configured to split the second coolant exiting the heat exchanger into a first volume and a second volume, and route the first volume to the cooling source component through the bypass, and the second volume to the cooling source component through the heat exchanger.
12. The cooling system of clause 7, further comprising a sensor placed on the first coolant circuit, and connected to the thermostatic valve, wherein the sensor is configured to actuate the thermostatic valve based on a temperature of the first coolant either exiting the VFD or entering into the VFD.
13. The cooling system of clause 7, wherein a sensor configured to measure temperature of the second coolant is embedded in the thermostatic valve.
14. The cooling system of clause 1, further comprising a pair of three-way valves defining a bypass on the first coolant circuit and/or the second coolant circuit, wherein the pair of three-way valves is configured to periodically open and/or close the connections to the bypass.
15. The cooling system of clause 14, wherein the pair of three-way valves are controlled based on temperature of either the first coolant or the second coolant measured by a sensor placed on the first coolant circuit or the second coolant circuit, respectively.
16. The cooling system of clause 1, wherein the cooling source component is a condenser or an evaporator.
17. The cooling system of clause 1, wherein the second coolant is condenser water or evaporator water.
18. The cooling system of clause 1, further comprising an oil circuit associated with an oil-cooled device, wherein the oil circuit is routed through the heat exchanger and is connected to the double-shafted pump, and wherein the double-shafted pump is configured to circulate oil through the oil circuit.
19. A cooling system for an oil-cooled device, comprising:
   a heat exchanger;
   an oil circuit routed through the heat exchanger and the oil-cooled device;
   a coolant circuit routed through the heat exchanger and a cooling source component; and
   a double-shafted pump connected to at least one of: the oil circuit and the coolant circuit, and configured to circulate oil through the oil circuit and a coolant through the coolant circuit.

## Claims

1. A cooling system for a variable frequency drive (VFD) (102), the cooling system comprising:
a heat exchanger (104);
a first coolant circuit (108) routed through the heat exchanger and the VFD;
a second coolant circuit (110) routed through the heat exchanger and a cooling source component (106); and
a double-shafted pump (112) connected to the first coolant circuit (108) and the second coolant circuit (110), and configured to circulate a first coolant through the first coolant circuit and a second coolant through the second coolant circuit for cooling the VFD.

2. The cooling system of claim 1, wherein the VFD comprises a heat sink (101) configured to eject heat from the VFD to the first coolant in the first coolant circuit (108).

3. The cooling system of claim 1 or 2, further comprising a thermostatic valve (114b) and a three-way valve (114a) defining a bypass (116a) on the first coolant circuit.

4. The cooling system of claim 3, wherein the thermostatic valve (114b) is disposed downstream of the VFD, and the three-way valve (114a) is disposed downstream of the heat exchanger (104), or vice-versa.

5. The cooling system of claim 3 or 4, further comprising a sensor (118) placed upstream of the VFD, and connected to the thermostatic valve (114b) via a capillary connection (117), optionally wherein the sensor (118) is configured to actuate the thermostatic valve (114b) based on a temperature of the first coolant entering into the VFD.

6. The cooling system of claim 1 or 2, further comprising a thermostatic valve (114b) and a three-way valve (114a) defining a bypass (116b; 116c) on the second coolant circuit (110).

7. The cooling system of claim 6, wherein the thermostatic valve (114b) and/or the three-way valve (114a) is disposed downstream of the cooling source component (106), and the three-way valve (114a) is disposed downstream of the heat exchanger (104), or vice-versa.

8. The cooling system of claim 6 or 7, further comprising a sensor (118) configured to actuate the thermostatic valve (114b), based on a temperature of the second coolant entering into the heat exchanger (104).

9. The cooling system of claim 8, wherein the sensor (118) is disposed upstream of the heat exchanger (104) on the second coolant circuit (110), or wherein the sensor (118) is disposed on the first coolant circuit (108); and/or wherein the sensor (118) is coupled to the thermostatic valve (114b) via a capillary connection (117).

10. The cooling system of any preceding claim, wherein a sensor (118) is configured to determine temperature of at least one of the first coolant or the second coolant.

11. The cooling system of claim 1, further comprising a pair of three-way valves defining a bypass on the first coolant circuit and/or the second coolant circuit, wherein the pair of three-way valves is configured to periodically open and/or close the connections to the bypass, optionally, wherein the pair of three-way valves are controlled based on temperature of either the first coolant or the second coolant determined by a sensor placed on the first coolant circuit or the second coolant circuit, respectively.

12. The cooling system of any preceding claim, wherein the cooling source component (106) comprises a condenser or an evaporator; and/or wherein the second coolant comprises condenser water or evaporator water.

13. The cooling system of claim 1, further comprising an oil circuit (109) associated with an oil-cooled device (103), wherein the oil circuit (109) is routed through the heat exchanger (104) and is connected to the double-shafted pump (112), and wherein the double-shafted pump is configured to circulate oil through the oil circuit.

14. A cooling system for an oil-cooled device (103), comprising:
a heat exchanger (104);
an oil circuit (109) routed through the heat exchanger (104) and the oil-cooled device (103);
a coolant circuit (110) routed through the heat exchanger (104) and a cooling source component (106); and
a double-shafted pump (112) connected to at least one of: the oil circuit (103) and the coolant circuit (110), and configured to circulate oil through the oil circuit and a coolant through the coolant circuit.

15. A method of operating a cooling system for a variable frequency drive (VFD), the cooling system including a heat exchanger (104), a first coolant circuit (108), a second coolant circuit (110), and a double-shafted pump (112) connected to the first coolant circuit and the second coolant circuit, and at least one valve (114b) defining a bypass on at least one of the first coolant circuit or the second coolant circuit, wherein the method comprises:
circulating, by the double-shafted pump (112), a first coolant through the first coolant circuit (108) and a second coolant through the second coolant circuit (110);
determining a temperature of at least one of the first coolant or the second coolant downstream of at least one of the heat exchanger (104) or a cooling source component (106) of the second coolant circuit (110); and
actuating the at least one valve (114b) based on the determined temperature.
